Europäisches Patentamt

European Patent Office

Office européen des brevets

(19)

(11) Numéro de publication: **0 201 410**
**A2**

(12) # DEMANDE DE BREVET EUROPEEN

(21) Numéro de dépôt: **86400928.7**

(51) Int. Cl.⁴: **A45C 11/18**

(22) Date de dépôt: **28.04.86**

(30) Priorité: **07.05.85 FR 8506968**

(43) Date de publication de la demande:
**17.12.86 Bulletin 86/46**

(84) Etats contractants désignés:
**BE DE FR GB IT LU NL**

(71) Demandeur: **Anbar, Gassan**
**13, rue Casimir Vincent**
**F-92700 Colombes(FR)**

(72) Inventeur: **Anbar, Gassan**
**13, rue Casimir Vincent**
**F-92700 Colombes(FR)**

(74) Mandataire: **Sauvage, Renée**
**CABINET SAUVAGE 100 bis, avenue de**
**Saint-Mandé**
**F-75012 Paris(FR)**

(54) **Etui pour coupon intégrant un cicuit électronique et/ou une piste magnétique.**

(57) Etui pour coupon (C) du type comportant un support et un feuillet de matière souple (13) destiné à former, avec le support, un logement pour le coupon (C), caractérisé en ce que le feuillet de matière souple (13) est fixé par ses bords (5, 7, 6'), sauf un (14), sur le support, la longueur des bords du feuillet adjacents au bord non fixé étant inférieure à celle du coupon (C), une découpe (17) étant ménagée dans le bord opposé au bord non fixé du feuillet (13), et cette découpe n'étant pas fixée au support de façon à constituer un orifice d'aération qui, d'une part, fait communiquer avec l'extérieur la partie du coupon (C) insérée dans le logement et, d'autre part, facilite le retrait du coupon (C) de son logement sans déformation dudit coupon.

FIG 3

EP 0 201 410 A2

Rank Xerox

La présente invention concerne un étui pour coupon du type comportant un support et un feuillet de matière souple destiné à former, avec le support, un logement pour le coupon. Un tel étui est conçu pour protéger un coupon, notamment du type carte à mémoire et/ou à piste magnétique.

Sous son aspect général, l'invention s'applique donc à un étui destiné à tout type de coupon comportant au moins un dispositif intégré constituant une mémoire dans laquelle sont inscrites des données et/ou des instructions destinées à être lues par une machine après introduction du coupon dans celle-ci.

On sait qu'un problème majeur, pour l'utilisation de ces coupons ou cartes, réside dans le fait que les machines rejettent, ou au contraire ne restituent pas, les coupons dans le cas où ceux-ci présentent une anomalie telle qu'une souillure - (poussière), un défaut de planéité (coupon ou carte voilés) ou dans le cas où elles sont humides. Ces anomalies sont dues directement au fait que l'utilisateur du coupon ou de la carte manipule ceux-ci avec plus ou moins de soin et surtout les conserve dans des étuis mal adaptés. Outre la gêne créée aux utilisateurs, les conséquences de ces anomalies peuvent être graves et surtout coûteuses puisque toute carte non restituée, bloquée dans les distributeurs de billets de banque par exemple, rend l'appareil inutilisable et exige un dépannage.

La présente invention propose un nouveau type d'étui permettant d'éviter ces inconvénients dus aux manipulations par l'utilisateur.

A cet effet, l'étui selon l'invention est caractérisé en ce que le feuillet de matière souple est fixé par ses bords, sauf un, sur le support, la longueur des bords du feuillet adjacents au bord non fixé étant inférieure à celle du coupon, une découpe étant ménagée dans le bord opposé au bord non fixé du feuillet et cette découpe n'étant pas fixée au support de façon à constituer un orifice d'aération qui, d'une part, fait communiquer avec l'extérieur la partie du coupon insérée dans le logement et, d'autre part, facilite le retrait du coupon hors de son logement sans déformation dudit coupon.

La plaque support rigide, en maintenant parfaitement le coupon, évite la torsion ou le voilage de celui-ci, tandis que l'aération du coupon, assuré par l'orifice prévu dans le feuillet de matière souple, évite les phénomènes de condensation et la formation sur le coupon d'une couche humide préjudiciable.

Dans une forme d'exécution pratique, l'étui selon l'invention est rectangulaire et le feuillet souple est fixé au support par un premier, deuxième et troisième de ses côtés adjacents, l'orifice d'aération étant pratiqué dans une partie dudit deuxième côté du feuillet.

De préférence, le support est constitué par une plaque rigide ou semi-rigide de dimensions au moins égales à celles du coupon, la face de la plaque destinée à être en contact avec le coupon étant garnie d'une couche de poils souples, de type feutre ou velours.

La couche de poils permet d'éliminer les poussières ou corps étrangers qui auraient pu se déposer sur les parties actives du coupon, tout en combattant les effets néfastes de l'électricité statique.

Avantageusement, la plaque rigide est un noyau enfermé dans une enveloppe souple.

Dans une autre forme d'exécution, l'étui est constitué de deux volets articulés l'un à l'autre par un de leurs côtés communs.

On décrira à présent, à titre d'exemples non limitatifs, trois formes de réalisation de la présente invention en référence aux dessins annexés dans lesquels :

-la figure 1 est une vue en perspective d'une première forme de réalisation ;

-la figure 2 est une vue en perspective d'une deuxième forme de réalisation, et

-la figure 3 est une vue de face d'une troisième forme de réalisation.

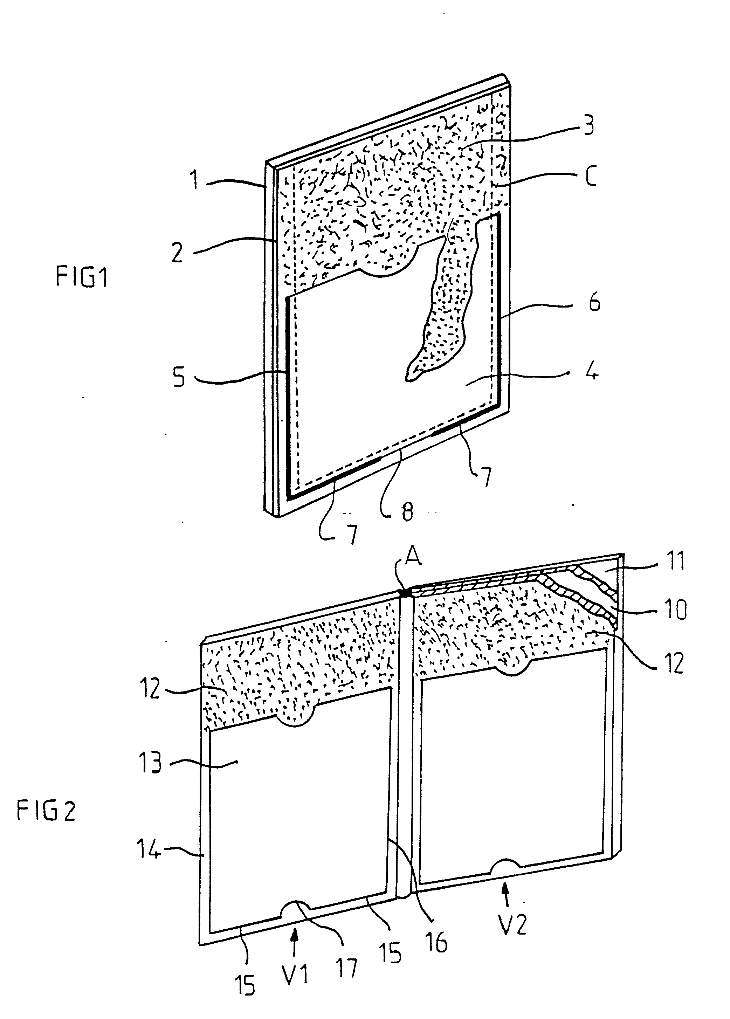

L'étui représenté à la figure 1 est constitué par une plaque 1 de forme générale rectangulaire en matière rigide ou au moins semi-rigide tel que carton dur, matière plastique ou toute autre matière appropriée.

Une face de la plaque est recouverte de poils ras 3 appartenant de préférence à une pièce de feutre 2 ou de tissu type velours qui est fixée sur la plaque par tout moyen approprié, par exemple collage.

La partie inférieure de la plaque est munie d'un feuillet de matière souple 4, par exemple en matière plastique transparente, dont les bords latéraux 5 et 6 sont fixés à la plaque par collage ou soudage, le long des bords latéraux de celle-ci.

Le bord inférieur du feuillet 4 est fixé partiellement au bord de la plaque 1 en 7 alors que la partie 8 n'est pas fixée, ménageant ainsi, avec la plaque, un passage d'aération mettant en communication avec l'extérieur le logement prévu entre plaque et feuillet et dans lequel est destiné à être

introduit un coupon (ou carte) C représenté en pointillés. On notera que les dimensions de la plaque 1 sont légèrement supérieures à celles du coupon.

L'étui représenté à la figure 2 est constitué de deux volets V1 et V2 articulés l'un à l'autre en A pour pouvoir se replier l'un sur l'autre. Chaque volet est constitué d'une plaque rigide 10 comme celle de la figure 1, enrobée dans une enveloppe souple 11, 12 par exemple en matière plastique.

La face interne 12 de l'enveloppe est couverte de poils, par exemple, par fixation d'une pièce de feutre ou de velours.

Le feuillet de matière souple 13 est fixé par trois de ses côtés adjacents 14, 15 et 16 sur l'enveloppe souple (par collage ou soudage). Une découpe 17, prévue à la base du feuillet souple 13, assure l'aération du logement de l'étui.

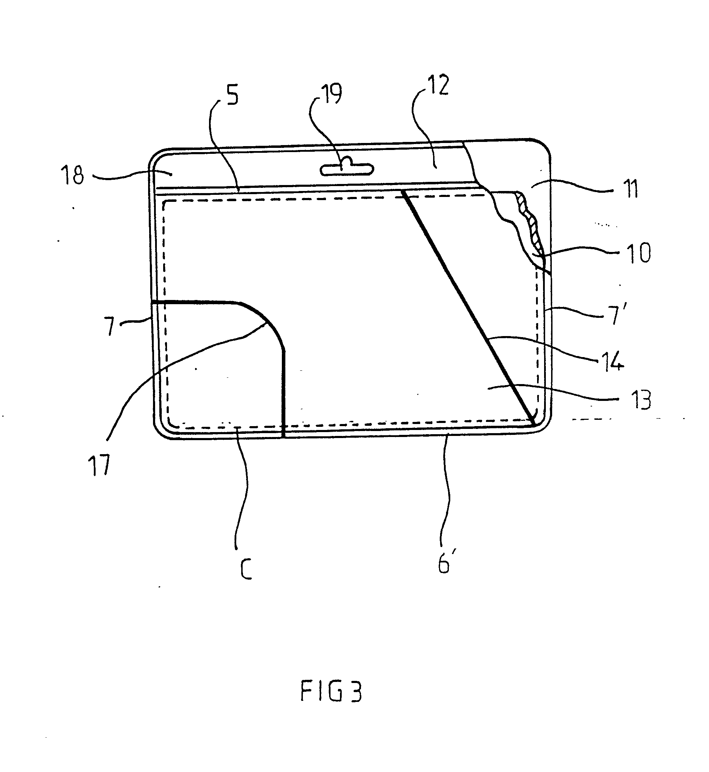

L'étui représenté à la figure 3 est constitué d'un support formé d'une face envers 11 et d'une face endroit 12 soudées le long des lignes 5, 6, 6', 7 et 7'. Entre les faces 11 et 12 est interposé, avant soudage, un noyau de carton 10 pour donner de la rigidité au support. Les lignes de soudage 5, 7 et 6' affectent également une partie des bords d'un feuillet de matière plastique souple et transparente 13. Ce feuillet 13 présente un bord libre en biais 14 permettant l'introduction d'un coupon C figuré en pointillés et, à l'opposé, un bord libre arrondi 17 formant découpe d'aération.

Les lignes de soudage 5 et 6 définissent, entre elles, une languette 18 de suspension présentant une boutonnière 19 adaptée à la mise en place d'une pince, par exemple.

Il est bien entendu que la présente invention n'est pas limitée aux formes d'exécution décrites et représentées.

**Revendications**

1) Etui pour coupon (C) du type comportant un support (1) et un feuillet de matière souple (4) destiné à former, avec le support, un logement pour le coupon (C), caractérisé en ce que le feuillet de matière souple (4) est fixé par ses bords (5, 6, 7), sauf un, sur le support (1), la longueur des bords du feuillet adjacents au bord non fixé étant inférieure à celle du coupon C, une découpe (17) étant ménagée dans le bord opposé au bord non fixé du feuillet (4), et cette découpe n'étant pas fixée au support de façon à constituer un orifice d'aération qui, d'une part, fait communiquer avec l'extérieur la partie du coupon (C) insérée dans le logement et d'autre part facilite le retrait du coupon (C) de son logement sans déformation dudit coupon.

2) Etui selon la revendication (1) de forme rectangulaire, caractérisé en ce que le feuillet souple (4) est fixé au support (1) par un premier, deuxième et troisième de ses côtés adjacents (5, 7, 6), l'orifice d'aération (17) étant pratiqué dans une partie dudit deuxième côté (7) du feuillet (4).

3) Etui selon l'une quelconque des revendications 1 ou 2, caractérisé en ce que le support (1) est constitué par une plaque rigide ou semi-rigide (10) de dimensions au moins égales à celles du coupon C, la face de la plaque (3) destinée à être en contact avec le coupon étant garnie d'une couche de poils souples, de type feutre ou velours.

4) Etui selon la revendication 3, caractérisé en ce que la plaque rigide (3) est constituée par un noyau (10) enfermé dans une enveloppe souple.

5) Etui selon l'une quelconque des revendications 1 à 4, caractérisé en ce qu'il est constitué de deux volets (V1, V2), articulés l'un à l'autre par un de leurs côtés communs (A).

0 201 410

FIG 1

FIG 2

FIG 3